# EUROPEAN PATENT APPLICATION

(11) **EP 2 787 796 A1**
(43) Date of publication of application: **08.10.2014**
(21) Application number: 12862999.5
(22) Date of filing: 13.08.2012
(51) Int. Cl.: H05K 3/12, H05K 3/18

(54) **CONDUCTIVE FILM FORMING METHOD, COPPER FINE PARTICLE-DISPERSED LIQUID, AND CIRCUIT BOARD**

(30) Priority: 27.12.2011 JP 2011284611
(71) Applicant: Ishihara Chemical Co., Ltd., Kobe-shi Hyogo-ken 652-0806 (JP); Applied Nanotech Holdings, Inc., Austin, TX 78758 (US)
(72) Inventor: KAWATO, Yuichi, Kobe-shi Hyogo 652-0806 (JP); MITA, Tomohiro, Kobe-shi Hyogo 652-0806 (JP); MAEDA, Yusuke, Kobe-shi Hyogo 652-0806 (JP); KUDO, Tomio, Kobe-shi Hyogo 652-0806 (JP)
(74) Representative: Hoefer & Partner
(86) International application number: PCT/JP2012/070600
(87) International publication number: WO 2013/099345

(57) **Abstract**

An object is to provide a conductive film forming method which can form a conductive film having low electric resistance on a base material by utilizing photo sintering even when the base material has low heat resistance. A conductive film forming method is a method in which a conductive film 2 is formed on a base material 1, and the method includes the steps of forming a film 3b composed of copper particulates 4 on a base material, subjecting the film 3b to photo sintering, and applying plating to the photo-sintered film 3c. Whereby, it is possible to form a conductive film 2 on a base material 1 by lowering irradiation energy of light in photo sintering even when the base material 1 has low heat resistance. Since the conductive film 2 includes a plated layer 21, electric resistance decreases.

## Description

### TECHNICAL FIELD

The present invention relates to a conductive film forming method in which a conductive film is formed on a base material utilizing photo sintering, a copper particulate dispersion used in this conductive film forming method, and a circuit board produced by using this conductive film forming method.

### BACKGROUND ART

There has hitherto existed a printed board in which a circuit composed of a copper foil is formed on a substrate by photolithography. Photolithography includes the step of etching a copper foil and high costs are required for a treatment of waste fluid generated by etching.

There has been known, as the technology requiring no etching, a method in which a conductive film is formed on a substrate using a copper particulate dispersion (copper ink) containing copper particulates (copper nanoparticles) dispersed in a dispersion vehicle (see, for example, Patent Document 1). According to this method, a liquid film of a copper particulate dispersion is formed on a substrate, and the liquid film is dried to form a film composed of copper particulates. This film undergoes bulking due to photo sintering, and thus a conductive film is formed. Glass or polyimide having high heat resistance is used as a material of a substrate so that the material can endure heat generation of copper particulates due to absorption of energy of light.

In order to use a material having comparatively low heat resistance, such as polyethylene terephthalate (PET) in the substrate, it is necessary to lower irradiation energy of light in photo sintering. However, low irradiation energy leads to insufficient bulking of a film composed of copper particulates, resulting in high electric resistance (sheet resistance) of the thus formed conductive film. Low irradiation energy also leads to insufficient bulking of a film composed of copper particulates, and thereby the thus formed conductive film is likely to peel off in the film. Therefore, it was impossible to form a conductive film on a substrate having low heat resistance by utilizing photo sintering. Even when using a substrate having high heat resistance, it has been desired to further lower electric resistance of a conductive film formed by utilizing photo sintering.

Patent Document 1 : U.S. Patent Application Publication No. 2008/0286488

### SUMMARY OF INVENTION

### TECHNICAL PROBLEM

The present invention is made so as to solve the above-mentioned problems and an object thereof is to provide a conductive film forming method which can form a conductive film having low electric resistance on a base material by utilizing photo sintering even when the base material has low heat resistance, a copper particulate dispersion used in this conductive film forming method, and a circuit board produced by using this conductive film forming method.

### SOLUTION TO PROBLEM

A conductive film forming method of the present invention is a method in which a conductive film is formed on a base material, and is characterized by including the steps of forming a film composed of copper particulates on a base material, subjecting the film to photo sintering, and applying plating to the photo-sintered film.

In this conductive film forming method, the base material is preferably a thermoplastic resin.

In this conductive film forming method, the thermoplastic resin is preferably selected from the group consisting of polyethylene terephthalate, polyethylene naphthalate, polyvinyl chloride, polyvinylidene chloride, polyvinyl alcohol, polystyrene, a styrene-acrylonitrile copolymer, a styrene-butadiene-acrylonitrile copolymer, polyethylene, a styrene-vinyl acetate copolymer, polypropylene, polyacetal, polymethyl methacrylate, a methacryl-styrene copolymer, cellulose acetate, polycarbonate, polyamide, thermoplastic polyurethane and polytetrafluoroethylene.

In this conductive film forming method, the base material is preferably selected from the group consisting of glass, glass epoxy, ceramics, stainless steel, silicon wafer, polyimide and transparent polyimide.

In this conductive film forming method, the plating is preferably electroplating in which plated metal is selected from the group consisting of copper, nickel, tin, chromium, palladium, gold, bismuth, cobalt, iron, silver, lead, platinum, iridium, zinc, indium, ruthenium and rhodium.

In this conductive film forming method, the plating may be electroless plating in which plated metal is selected from the group consisting of copper, tin, silver, nickel, palladium and gold.

In this conductive film forming method, the step of forming a film composed of copper particulates on a base material preferably includes the steps of:
forming a liquid film composed of a copper particulate dispersion, which contains copper particulates dispersed in a liquid, on a base material, and
drying the liquid film.

A copper particulate dispersion of the present invention is used in the above conductive film forming method, and is characterized by including copper particulates, each having a center particle diameter of 1 nm or more and less than 100 nm, at least one kind of a dispersion vehicle containing the copper particulates, and at least one kind of a dispersant which allows the copper particulates to disperse in the dispersion vehicle.

A circuit board of the present invention is characterized by including a circuit including a conductive film formed by the above conductive film forming method on a substrate.

### ADVANTAGEOUS EFFECTS OF INVENTION

According to the conductive film forming method of the present invention, it is possible to form a conductive film on a base material by lowering irradiation energy of light in photo sintering even when the base material has low heat resistance. Since this conductive film includes a plated layer, electric resistance decreases.

### DESCRIPTION OF THE DRAWINGS

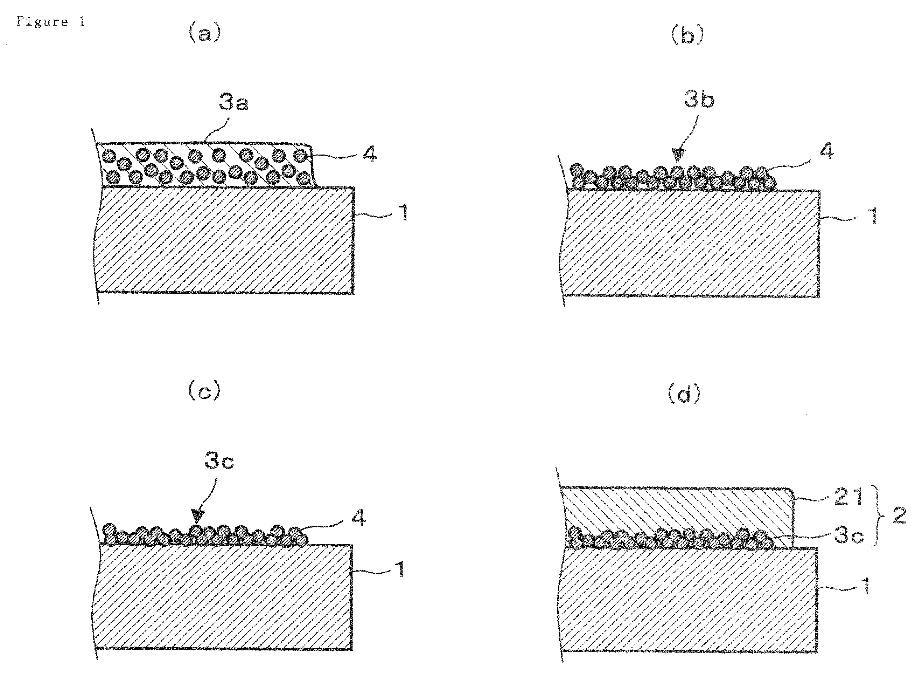

Figs. 1(a) to 1(d) are cross-sectional schematic views showing formation of a conductive film by a conductive film forming method according to an embodiment of the present invention in chronological order.

### DESCRIPTION OF EMBODIMENTS

The conductive film forming method according to an embodiment of the present invention will be described with reference to Figs. 1(a) to 1(d). This conductive film forming method is a method in which a conductive film 2 is formed on a base material 1. As shown in Fig. 1(a), a liquid film 3a composed of a copper particulate dispersion is formed on a base material 1. The copper particulate dispersion is a liquid containing copper particulate 4 dispersed in a liquid. The base material 1 may have low heat resistance and is, for example, a substrate composed of a thermoplastic resin. Examples of the thermoplastic resin include, but are not limited to, polyethylene terephthalate (PET), polyethylene naphthalate (PEN), polyvinyl chloride, polyvinylidene chloride, polyvinyl alcohol, polystyrene, styrene-acrylonitrile copolymer, styrene-butadiene-acrylonitrile copolymer, polyethylene, styrene-vinyl acetate copolymer, polypropylene, polyacetal, polymethyl methacrylate, methacryl-styrene copolymer, cellulose acetate, polycarbonate, polyamide, thermoplastic polyurethane, polytetrafluoroethylene and the like. The liquid film 3a on the base material 1 is formed, for example, by a printing method. In the printing method, a copper particulate dispersion is used as an ink for printing, and a predetermined pattern is printed on the base material 1 by a printer, and thus forming a liquid film 3a of the pattern. Next, the liquid film 3a is dried. As shown in Fig. 1(b), copper particulates 4 remain on the base material 1 by drying of the liquid film 3a, and thus a film 3b composed of copper particulates 4 is formed on the base material 1.

Next, the film 3b composed of copper particulates 4 is irradiated with light and this film 3b is subjected to photo sintering. In photo sintering, reduction of a surface-oxidized film of copper particulates 4 of the film 3b and sintering of copper particulates 4 occur. As shown in Fig. 1(c), copper particulates 4 are mutually melted and welded to the base material 1 in sintering. Photo sintering is performed at room temperature under atmospheric pressure. A light source used in photo sintering is, for example, a xenon lamp. A laser device may be used as the light source. Irradiation energy of light irradiated from the light source is set in accordance with heat resistance of the base material 1 and is 0.1 J/cm² or more and 100 J/cm² or less. The irradiation time is 0.1 ms or more and 100 ms or less. Irradiation may be performed once or plural times (multistage irradiation). The photo-sintered film 3c undergoes bulking by irradiation with light and is imparted with conductivity, and also adheres to the base material 1. This film 3c may have high electric resistance (sheet resistance) as long as it has conductivity.

Next, plating is applied to the photo-sintered film 3c. This plating is electroplating or electroless plating. Examples of the plated metal in electroplating include, but are not limited to, copper, nickel, tin, chromium, palladium, gold, bismuth, cobalt, iron, silver, lead, platinum, iridium, zinc, indium, ruthenium, rhodium and the like. Examples of the plated metal in electroless plating include, but are not limited to copper, tin, silver, nickel, palladium, gold and the like. The plating may be alloy plating. In the electroplating, the photo-sintered film 3c is immersed in a plating solution and serves as a cathode which is a seed layer. In the electroless plating, the photo-sintered film 3c serves as a catalytically active seed layer to an oxidation reaction of a reducing agent contained in the plating solution. As shown in Fig. 1(d), a plated layer 21 is formed on the film 3c by plating, and thus increasing a thickness of the conductive film 2 (increasing in plating thickness). The thickness of the conductive film before applying plating is about 0.01 µm or more and 2 µm or less. The thickness of the conductive film after plating is about 0.1 µm or more and 50 µm or less.

In this conductive film forming method, when using a material having low heat resistance in the base material 1, energy of light, with which the film 3b composed of copper particulates 4 is irradiated, is set to low energy so as not to cause damage of the base material 1, thus leading to insufficient bulking of the photo-sintered film 3c, and resulting in high electric resistance (sheet resistance). Since this film 3c has high electric resistance but has conductivity, it can be used as a seed layer in electroplating. In the electroless plating, the electric resistance of the seed layer should never be a problem. Accordingly, it is possible to apply plating to the photo-sintered film 3c. Since the conductive film 2 includes a plated layer 21, electric resistance of the conductive film 2 corresponds to a resistance value of bulk metal.

When using a material having low heat resistance in the base material 1, a film 3c formed by photo sintering of a film 3b composed of copper particulates 4 can achieve adhesiveness with the base material 1. However, peeling is likely to occur inside the film 3c. This is because small irradiation energy of light in photo sintering leads to insufficient bulking of the film 3c.

However, the inventors of the present invention have found by the test that, when plating is applied to the film 3c formed on a base material 1 having low heat resistance, it becomes difficult for the formed conductive film 2 to peel off. Particularly, when using polyethylene terephthalate (PET) in the base material 1, adhesiveness of the conductive film 2 becomes satisfactory. Polyethylene terephthalate is a thermoplastic resin and has low continuous heat-resistant temperature of about 150°C.

It is considered that such satisfactory adhesiveness of the conductive film 2 is due to the following action. When the film 3b composed of copper particulates 4 is subjected to photo sintering, copper particulates 4 absorb energy of light to generate heat, while copper particulates 4 in contact with the base material 1 are strongly welded so as to bite into the base material 1 having low heat resistance. Even if spaces exist among copper particulates 4 due to insufficient bulking of the photo-sintered film 3c by photo sintering, the space is filled with metal which is precipitated in plating, and thus the film undergoes bulking. The conductive film 2 formed by such bulking is prevented from peeling from the base material 1 since copper particulates 4 welded strongly to the base material 1 serves as an anchor. The above-mentioned action is one theory for explaining the test results and does not limit the present invention.

In contrast, when using a material having high heat resistance, such as glass or polyimide in the base material 1, the film 3c formed by photo sintering of the film 3b composed of copper particulates 4 has satisfactory adhesiveness to the base material 1 to such a degree that the film is not peeled by a adhesive tape, and has low electric resistance (sheet resistance). This is because welding to the base material 1 and bulking of the film 3c are sufficiently performed since it is possible to increase irradiation energy of light in photo sintering.

It is necessary to increase the film thickness so as to further lower electric resistance of this film 3c. It is considered to apply plating to the film 3c so as to increase the film thickness. However, the inventors of the present invention have found by the test that, when plating is applied to the film 3c formed on a base material 1 having high heat resistance to form a conductive film 2, it becomes easy to peel the conductive film 2 from the base material 1.

It is considered that such deterioration of adhesiveness to the conductive film 2 by plating is due to the following action. If irradiation energy of light in photo sintering is sufficiently large, the film 3c formed by photo sintering of the film 3b composed of copper particulates 4 has satisfactory adhesiveness to the base material 1 to such a degree that the film is not peeled by a adhesive tape. However, because of high heat resistance of the base material 1, copper particulates 4 are not sufficiently welded as compared with the base material having low heat resistance. Therefore, it becomes easy for the conductive film 2 formed by applying plating to the film 3c to peel from the base material 1 due to internal stress which remains inside the plated layer 21 of the conductive film 2. Note that the above-mentioned action is one theory for explaining the test results and does not limit the present invention.

In case another layer is further laminated on the exposed surface of the conductive film 2 and the base material 1, or the exposed surface is sealed with a resin, peeling of the conductive film 2 is prevented. Therefore, the material having high heat resistance may be used in the base material 1. Examples of the material having high heat resistance include, but are not limited to, glass, glass epoxy, ceramics, stainless steel, silicon wafer, polyimide, transparent polyimide and the like. Since the thickness of the conductive film 2 on the base material 1 increases by including the plated layer 21, electric resistance decreases and current capacity increases.

A copper particulate dispersion used in this conductive film forming method will be described in detail. The copper particulate dispersion includes copper particulates (copper nanoparticles), each having a center particle diameter of 1 nm or more and less than 100 nm, at least one kind of a dispersion vehicle containing the copper particulates, and at least one kind of a dispersant. The dispersion vehicle is, for example, a protic dispersion vehicle, or an aprotic polar dispersion vehicle having a dielectric constant of 30 or more. The dispersant allows copper particulates to disperse in a dispersion vehicle and is, for example, a compound having at least one acidic functional group and a molecular weight of 200 or more and 100,000 or less, or a salt thereof.

Examples of the protic dispersion vehicle include, but are not limited to, 3-methoxy-3-methylbutanol, triethylene glycol monomethyl ether, diethylene glycol monobutyl ether, diethylene glycol monomethyl ether, propylene glycol monobutyl ether, ethylene glycol monohexyl ether, ethylene glycol mono-tert-butyl ether, 2-octanol, 2-methylpentane-2,4-diol, ethylene glycol, propylene glycol, 1,5-pentanediol, diethylene glycol, triethylene glycol, glycerin, sorbitol and the like.

Examples of the aprotic polar dispersion vehicle having a dielectric constant of 30 or more include, but are not limited to, propylene carbonate, 1,3-dimethyl-2-imidazolidinone, hexamethylphosphoramide, N-methylpyrrolidone, N-ethylpyrrolidone, nitrobenzene, N, N-diethylformamide, N, N-dimethylacetamide, furfural, γ-butyrolactone, ethylene sulfite, sulfolane, dimethyl sulfoxide, succinonitrile, ethylene carbonate and the like.

The dispersant has, for example, a phosphoric acid group, a phosphonic acid group, a sulfonic acid group, a sulfuric acid group or a carboxyl group as an acidic functional group.

A circuit board produced by using the above conductive film forming method will be described. This circuit board includes a circuit on a substrate. The substrate is obtained by forming a material such as polyethylene terephthalate, polyethylene naphthalate or polymethyl methacrylate into a plate shape and is, for example, a flexible substrate or a rigid substrate. The circuit includes a conductive film formed by this conductive film forming method. The conductive film constitutes, for example, a conducting wire which electrically connects between circuit elements. The conductive film may constitute circuit elements or a portion thereof, for example, a coil, an electrode of a capacitor and the like.

The conductive film forming method according to the present embodiment can form a conductive film 2 on a base material 1 by lowering irradiation energy of light in photo sintering even when a base material 1 has low heat resistance. Since this conductive film 2 includes a plated layer 21, electric resistance decreases.

When using a material having low heat resistance, such as a thermoplastic resin in the base material 1, a conductive film 2 is welded to the base material 1 and the conductive film 2 undergoes bulking by plating even by lowering irradiation energy of light in photo sintering. Therefore, peeling from the base material 1 is prevented and also electric resistance decreases.

When using a material having high heat resistance in the base material 1, since the thickness of the conductive film 2 increases by plating, electric resistance decreases and current capacity increases.

In this conductive film forming method, a film 3b composed of copper particulates 4 can be easily formed by a printing method using a copper particulate dispersion.

Since the copper particulate dispersion used in the conductive film forming method shows small particle diameter of copper particulates 4 and contains a dispersant, it is possible to disperse copper particulates 4 in a dispersion vehicle.

It is possible to form a conductive film 2 having low electric resistance on a substrate composed of a resin having low heat resistance by producing a circuit board using this conductive film forming method.

Using the conductive film forming method of the present invention, a conductive film 2 was formed on a base material 1 as Example, and then the conductive film 2 thus formed was tested and evaluated.

### Example 1

Using copper particulates, each having a center particle diameter of 20 nm, a protic dispersion vehicle, and a compound having an acidic functional group as a dispersant, a copper particulate dispersion was prepared. A substrate made of polyethylene terephthalate (PET) (manufactured by DuPont Corporation under the trade name of "MELINEX (registered trademark) STXRF26", having a thickness of about 50 µm) was used as a base material 1. A continuous heat-resistant temperature of polyethylene terephthalate is about 150°C. On this substrate, a liquid film 3a of the copper particulate dispersion was formed. This liquid film 3a was dried to form a film 3b composed of copper particulates 4. This film 3b was subjected to photo sintering using a flush irradiation device with a xenon lamp to produce a sample substrate. Magnitude of irradiation energy in photo sintering was set so as not to cause thermal damage of the substrate. Sheet resistance of a photo-sintered film 3c in the sample substrate was 10 Ω/□.

Next, initial make-up of electrolytic bath of an electrolytic copper plating solution was performed. Electrolytic copper plating is electroplating in which plated metal is copper. The composition of this plating solution was as follows: copper sulfate pentahydrate as a supply source of divalent copper ions; 120 g/L, sulfuric acid; 180 g/L, hydrochloric acid; 25 ppm, and pure water (balance).

The sample substrate was subjected to a pretreatment in 10 wt% sulfuric acid and then immediately washed with pure water. The sample substrate was immersed in the above electrolytic copper plating solution, and electrolytic copper plating was applied to the sample substrate under the conditions of a liquid temperature of 25°C and a cathode current density of 4.0 A/dm². The sample substrate was washed with pure water and dried. The plating thickness of the conductive film 2 in the sample substrate was 10 µm.

Adhesiveness of a conductive film 2 was tested by a cross cut-adhesion method (JIS K5400) using 100 squares. In this test, 100 squares each measuring 1 mm × 1 mm were formed on a test surface of the conductive film 2 by cutting lines and an adhesive tape was applied to the cut squares and the adhesive tape was peeled, and then the test surface was observed. The number of squares, which remained without being peeled, was 100 among 100 squares.

### Example 2

In the same manner as in Example 1, except that a substrate made of polyimide (manufactured by Du Pont-Toray Co., Ltd. under the trade name of "Kapton EN", having a thickness of about 50 µm) was used as the base material 1, a film 3b composed of copper particulates 4 was formed on the substrate and this film 3b was subjected to photo sintering. The continuous heat-resistant temperature of polyimide is 400°C or higher. Irradiation energy in the photo sintering was set to lager energy as compared with Example 1. Sheet resistance of the photo-sintered film 3c was 1 Ω/□. In the same manner as in Example 1, electrolytic copper plating was applied to this film 3c to form a conductive film 2. The plating thickness of the conductive film 2 was 10 µm. Adhesiveness of this conductive film 2 was tested by a cross cut-adhesion method. The number of squares, which remained without being peeled, was 0 among 100 squares.

### Example 3

In the same manner as in Example 1, except that a substrate made of glass (slide glass) was used as the base material 1, a film 3b composed of copper particulates 4 was formed on the substrate and this film 3b was subjected to photo sintering. Irradiation energy in the photo sintering was set to lager energy as compared with Example 2. Sheet resistance of the photo-sintered film 3c was 1 Ω/□. In the same manner as in Example 1, electrolytic copper plating was applied to this film 3c to form a conductive film 2. The plating thickness of the conductive film 2 was 10 µm. Adhesiveness of this conductive film 2 was tested by a cross cut-adhesion method. The number of squares, which remained without being peeled, was 0 among 100 squares.

### Example 4

In the same manner as in Example 1, a film 3b composed of copper particulates 4 was formed on a substrate made of polyethylene terephthalate and this film 3b was subjected to photo sintering to produce a sample substrate. Sheet resistance of the photo-sintered film 3c in the sample substrate was from 4 Ω/□ to 40 Ω/□.

Next, initial make-up of electrolytic bath of an electroless copper plating solution was performed. The composition of this plating solution was as follows: copper sulfate pentahydrate as a supply source of divalent copper ions; 2.0 g/L, formaldehyde as a reducing agent; 5.0 g/L, ethylenediaminetetraacetic acid (EDTA) as a chelating agent; 30.0 g/L, sodium hydroxide as a pH adjustor; 9.6 g/L, and pure water (balance). The pH (20°C) of the plating solution was adjusted to 12.8.

The sample substrate was washed with pure water and then immersed in the above electroless copper plating solution, and electroless copper plating was applied under the conditions of a liquid temperature of 50°C to form a conductive film 2. The sample substrate with the conductive film 2 formed thereon was washed with pure water and dried. The plating thickness of the conductive film 2 was 3 µm. Adhesiveness of this conductive film 2 was tested by a cross cut-adhesion method. The number of squares, which remained without being peeled, was 100 among 100 squares.

### Example 5

In the same manner as in Example 4, except that a substrate made of polyethylene naphthalate (manufactured by Teijin DuPont Films Japan Limited under the trade name of "Teonex Q51", having a thickness of about 100 µm) was used as the base material, a film 3b composed of copper particulates 4 was formed on the substrate and this film 3b was subjected to photo sintering. The continuous heat-resistant temperature of polyethylene naphthalate is from 160°C to 180°C. Irradiation energy in the photo sintering was set so as not to cause thermal damage of the substrate. Sheet resistance of the photo-sintered film 3c was from 1 Ω/□ to 1.2 Ω/□ In the same manner as in Example 4, electroless copper plating was applied to this film 3c to form a conductive film 2. The plating thickness of the conductive film 2 was 3 µm. Adhesiveness of this conductive film 2 was tested by a cross cut-adhesion method. The number of squares, which remained without being peeled, was 100 among 100 squares.

### Example 6

In the same manner as in Example 4, except that a substrate made of polymethyl methacrylate (acryl) was used as the base material, a film 3b composed of copper particulates 4 was formed on the substrate and this film 3b was subjected to photo sintering. The continuous heat-resistant temperature of polymethyl methacrylate is 60°C to 94°C. Irradiation energy in the photo sintering was set so as not to cause thermal damage of the substrate. Sheet resistance of the photo-sintered film 3c was about 100,000 Ω/□. In the same manner as in Example 4, electroless copper plating was applied to this film 3c to form a conductive film 2. The plating thickness of the conductive film 2 was 3 µm. Adhesiveness of this conductive film 2 was tested by a cross cut-adhesion method. The number of squares, which remained without being peeled, was 100 among 100 squares.

### Example 7

In the same manner as in Example 4, except that a substrate made of polypropylene was used as the base material, a film 3b composed of copper particulates 4 was formed on the substrate and this film 3b was subjected to photo sintering. The continuous heat-resistant temperature of polypropylene is 107°C to 150°C. Irradiation energy in the photo sintering was set so as not to cause thermal damage of the substrate. Sheet resistance of the photo-sintered film 3c was 100 Ω/□. In the same manner as in Example 4, electroless copper plating was applied to this film 3c to form a conductive film 2. The plating thickness of the conductive film 2 was 3 µm. Adhesiveness of this conductive film 2 was tested by a cross cut-adhesion method. The number of squares, which remained without being peeled, was 100 among 100 squares.

### Example 8

In the same manner as in Example 4, except that a substrate made of alumina was used as the base material 1, a film 3b composed of copper particulates 4 was formed on the substrate and this film 3b was subjected to photo sintering. Irradiation energy in the photo sintering was set to lager energy as compared with Example 4. Sheet resistance of the photo-sintered film 3c was 1 Ω/□. In the same manner as in Example 4, electroless copper plating was applied to this film 3c to form a conductive film 2. The plating thickness of the conductive film 2 was 3 µm. Adhesiveness of this conductive film 2 was tested by a cross cut-adhesion method. The number of squares, which remained without being peeled, was 0 among 100 squares.

### Example 9

In the same manner as in Example 4, except that a silicon wafer was used as the base material 1, a film 3b composed of copper particulates 4 was formed on the substrate and this film 3b was subjected to photo sintering. Sheet resistance of the photo-sintered film 3c was 0.5 Ω/□. In the same manner as in Example 4, electroless copper plating was applied to this film 3c to form a conductive film 2. The plating thickness of the conductive film 2 was 3 µm. Adhesiveness of this conductive film 2 was tested by a cross cut-adhesion method. The number of squares, which remained without being peeled, was 0 among 100 squares.

### Example 10

In the same manner as in Example 4, except that a substrate made of polyimide (manufactured by Du Pont-Toray Co., Ltd. under the trade name of "Kapton EN", having a thickness of about 50 µm) was used as the base material 1, a film 3b composed of copper particulates 4 was formed on the substrate and this film 3b was subjected to photo sintering. Sheet resistance of the photo-sintered film 3c was 1 Ω/□. In the same manner as in Example 4, electroless copper plating was applied to this film 3c to form a conductive film 2. The plating thickness of the conductive film 2 was 3 µm. Adhesiveness of this conductive film 2 was tested by a cross cut-adhesion method. The number of squares, which remained without being peeled, was 0 among 100 squares.

### Example 11

In the same manner as in Example 4, except that a substrate made of transparent polyimide was used as the base material 1, a film 3b composed of copper particulates 4 was formed on the substrate and this film 3b was subjected to photo sintering. Sheet resistance of the photo-sintered film 3c was 1,000 Ω/□. In the same manner as in Example 4, electroless copper plating was applied to this film 3c to form a conductive film 2. The plating thickness of the conductive film 2 was 3 µm. Adhesiveness of this conductive film 2 was tested by a cross cut-adhesion method. The number of squares, which remained without being peeled, was 0 among 100 squares.

Examples 1 to 3 revealed that electroplating can be applied on the photo-sintered film 3c. Examples 4 to 11 revealed that electroless plating can be applied on the photo-sintered film 3c. Examples 1 and 4 to 7 revealed that, when using a material having low heat resistance in the base material 1, the plated conductive film 2 has satisfactory adhesiveness.

The present invention is not limited to configurations of the above-mentioned embodiments, and various modifications can be made without departing from the spirit or scope of the present invention. For example, the shape of the base material 1 is not limited to a plate shape and may be any three-dimensional shape.

### REFERENCE SIGN LIST

- 1 :: Base material
- 2 :: Conductive film
- 3a :: Liquid film
- 3b :: Film
- 4 :: Copper particulates (Copper nanoparticles)

## Claims

1. A conductive film forming method in which a conductive film is formed on a base material, the method comprising the steps of:
forming a film composed of copper particulates on a base material,
subjecting the film to photo sintering, and
applying plating to the photo-sintered film.

2. The conductive film forming method according to claim 1, wherein the base material is a thermoplastic resin.

3. The conductive film forming method according to claim 2, wherein the thermoplastic resin is selected from the group consisting of polyethylene terephthalate, polyethylene naphthalate, polyvinyl chloride, polyvinylidene chloride, polyvinyl alcohol, polystyrene, styrene-acrylonitrile copolymer, styrene-butadiene-acrylonitrile copolymer, polyethylene, styrene-vinyl acetate copolymer, polypropylene, polyacetal, polymethyl methacrylate, methacryl-styrene copolymer, cellulose acetate, polycarbonate, polyamide, thermoplastic polyurethane and polytetrafluoroethylene.

4. The conductive film forming method according to claim 1, wherein the base material is selected from the group consisting of glass, glass epoxy, ceramics, stainless steel, silicon wafer, polyimide and transparent polyimide.

5. The conductive film forming method according to any one of claims 1 to 4, wherein the plating is electroplating in which plated metal is selected from the group consisting of copper, nickel, tin, chromium, palladium, gold, bismuth, cobalt, iron, silver, lead, platinum, indium, zinc, indium, ruthenium and rhodium.

6. The conductive film forming method according to any one of claims 1 to 4, wherein the plating is electroless plating in which plated metal is selected from the group consisting of copper, tin, silver, nickel, palladium and gold.

7. The conductive film forming method according to any one of claims 1 to 6, wherein the step of forming a film composed of copper particulates on a base material includes the steps of:
forming a liquid film composed of a copper particulate dispersion, which contains copper particulates dispersed in a liquid, on a base material, and
drying the liquid film.

8. A copper particulate dispersion used in the conductive film forming method according to claim 7, comprising:
copper particulates, each having a center particle diameter of 1 nm or more and less than 100 nm,
at least one kind of a dispersion vehicle containing the copper particulates, and
at least one kind of a dispersant which allows the copper particulates to disperse in the dispersion vehicle.

9. A circuit board comprising a circuit including a conductive film formed by the conductive film forming method according to any one of claims 1 to 7 on a substrate.
